# FASCICULE DE BREVET EUROPEEN

(11) **EP 3 163 698 B1**
(45) Date de publication et mention de la délivrance du brevet: **15.08.2018**
(21) Numéro de dépôt: 16306344.9
(22) Date de dépôt: 12.10.2016
(51) Int. Cl.: H02G 3/08

(54) **SUPPORT D'APPAREILLAGE ÉLECTRIQUE**
UNTERSTÜTZUNG ELEKTRISCHEN GERÄTS
SUPPORT OF ELECTRICAL APPARATUS

(30) Priorité: 28.10.2015 FR 1560323
(43) Date de publication de la demande: 03.05.2017
(73) Titulaire: Legrand France, 87000 Limoges (FR); Legrand SNC, 87000 Limoges (FR)
(72) Inventeur: BARRUCHE, Alain, 87230 Bussière Galant (FR)
(74) Mandataire: Jacobacci Coralis Harle

(56) Documents cités:
- EP-A1- 1 675 235
- EP-A1- 1 675 236
- FR-A1- 2 727 260
- FR-A1- 2 909 810
- FR-A1- 2 941 099
- Legrand: "Legrand - Plexo composable boîtiers et supports plaques", , 28 février 2012 (2012-02-28), XP055281175, Extrait de l'Internet: URL:http://www.laboutiquedepke.fr/media/ma gentypes/2015-07-29-072512_legrand-69685-f m.pdf [extrait le 2016-06-16]

## Description

### DOMAINE TECHNIQUE AUQUEL SE RAPPORTE L'INVENTION

La présente invention concerne de manière générale la fixation d'appareillages électriques dans des boîtes électriques.

Elle concerne plus particulièrement un support d'appareillage en forme de cadre qui délimite une ouverture d'accueil d'un mécanisme d'appareillage et qui comporte quatre orifices en forme de trous de serrure répartis sur un même cercle moyen centré par rapport au cadre, chaque orifice présentant une extrémité circulaire et une partie allongée courbée autour du centre dudit cercle moyen.

Elle concerne également un appareillage électrique comprenant un mécanisme d'appareillage fixé dans un tel support d'appareillage.

### ARRIERE-PLAN TECHNOLOGIQUE

Il est courant d'utiliser un support d'appareillage pour rapporter un quelconque mécanisme d'appareillage, tel que par exemple un mécanisme d'interrupteur ou de prise de courant, dans une boîte électrique à encastrer dans une paroi quelconque ou à rapporter en saillie sur une telle paroi.

Un support d'appareillage monoposte comporte généralement une forme de cadre carré, avec quatre branches qui délimitent entre elles une ouverture centrale d'accueil du mécanisme d'appareillage.

Pour sa fixation à la boîte électrique, le support comporte généralement des orifices en forme de trous de serrure situés au centre de chacune de ses quatre branches. Ces orifices présentent chacun une partie principale de largeur constante et réduite, qui s'étend selon un arc-de-cercle centré sur le centre du cadre, et une extrémité circulaire.

La boîte électrique comporte en correspondance deux puits de vissage diamétralement opposés, dans lesquels sont initialement vissées deux vis.

Pour fixer le support d'appareillage à la boîte électrique, il suffit alors de dévisser légèrement ces vis, puis de rapporter le support à l'avant de la boîte électrique de telle manière que les têtes des vis passent au travers des extrémités circulaires des orifices. Reste ensuite à faire pivoter le support (pour le placer à l'horizontal) de manière que les têtes des vis se retrouvent au niveau des parties principales (de largeurs réduites) des orifices, et à revisser les vis de manière que leurs têtes s'appuient contre les bords des orifices.

De manière conventionnelle, les orifices sont tous orientés dans un même sens autour du centre du cadre (soit trigonométrique, soit horaire). Ainsi, que les deux vis de la boîte soient engagées dans l'une ou l'autre des paires d'orifices du support, le pivotement du support (avant de revisser les vis) se fait toujours dans le même sens (voir par exemple les documents FR2909810 et FR2941099). La forme des orifices permet de rattraper un décalage angulaire de la boîte électrique dans la paroi murale. Autrement formulé, lorsque la boîte électrique n'est pas parfaitement placée dans la paroi murale et que l'axe qui passe par les deux vis n'est pas exactement horizontal, la forme des orifices prévus dans le support offre un débattement angulaire qui permet de régler la position angulaire du support par rapport aux vis de la boîte électrique. Ainsi est-il possible de placer le support d'appareillage de telle sorte que deux de ses branches s'étendent horizontalement.

L'inconvénient majeur d'un tel support est que, si ce rattrapage angulaire est possible avec un débattement important dans un sens, il n'est possible qu'avec un débattement réduit dans l'autre sens.

En effet, il est possible d'incliner le support par rapport à la boîte de telle manière que les vis se rapprochent des fonds des parties allongées des orifices. Dans le sens opposé, il convient d'éviter que les vis se rapprochent trop des extrémités circulaires des orifices, au risque que le support ne se décroche inopportunément de la boîte électrique.

### OBJET DE L'INVENTION

Afin de remédier à l'inconvénient précité de l'état de la technique, la présente invention propose un support d'appareillage tel que défini dans l'introduction, dans lequel les orifices sont situés de telle manière que les extrémités circulaires de deux premiers orifices voisins sont tournées l'une vers l'autre et que les extrémités circulaires des deux autres orifices voisins sont tournées l'une vers l'autre.

Autrement formulé, tandis que deux orifices situés dans des branches opposées du cadre sont orientés dans un premier sens, les deux autres orifices sont orientés dans le sens opposé.

Ainsi, grâce à l'invention, si l'on constate, une fois le support bien positionné, que les têtes des deux vis engagées dans deux orifices opposées se trouvent en limite de rattrapage angulaire (c'est-à-dire qu'elles se rapprochent trop des extrémités circulaires de ces orifices), il est possible de tourner le support d'un quart-de-tour de manière à engager les vis dans les deux autres orifices du support. Alors, une fois le support bien positionné, les vis se retrouveront situées du côté du fond des parties principales de ces autres orifices (à l'opposé de leurs extrémités circulaires), ce qui assurera une bonne fixation du support d'appareillage à la boîte.

D'autres caractéristiques avantageuses et non limitatives du support d'appareillage conforme à l'invention sont les suivantes :
- la partie allongée de chaque orifice est délimitée entre deux bords latéraux chacun circonscrit à un cercle centré autour du centre dudit cercle moyen ;
- le support comporte une armature plate en matière métallique surmoulée d'une peau en matière synthétique isolante ;
- le support est réalisé d'une seule pièce en matière plastique ;
- le support comporte des moyens d'assujettissement d'un mécanisme d'appareillage ;
- le support comporte des moyens d'assujettissement d'une plaque d'habillage ;
- le support comporte quatre branches, dont deux branches sécables opposées présentant chacune une portion détachable qui s'étend sur toute la longueur de la branche concernée et qui est reliée d'un seul tenant au reste de la branche concernée par une ligne de cassure de moindre résistance ;
- le support comporte sur chacun des côtés de son bord périphérique extérieur des moyens d'assemblage à un autre support du même type ; et
- chaque branche sécable comporte sur sa ligne de cassure des moyens d'assemblage à un autre support du même type.

L'invention concerne également un appareillage électrique comportant un support d'appareillage tel que précité et un mécanisme d'appareillage fixé dans l'ouverture d'accueil dudit support d'appareillage.

Préférentiellement, le mécanisme d'appareillage comporte des moyens d'encliquetage démontables, accrochés au bord de l'ouverture d'accueil dudit support d'appareillage.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique en perspective d'un support d'appareillage conforme à l'invention, fixé sur une boîte électrique ;
- la figure 2 est une vue schématique de face du support d'appareillage de la figure 1 ; et
- les figures 3 et 4 sont des vues schématiques de face du support d'appareillage de la figure 1, fixé de deux manières différentes à la boîte électrique.

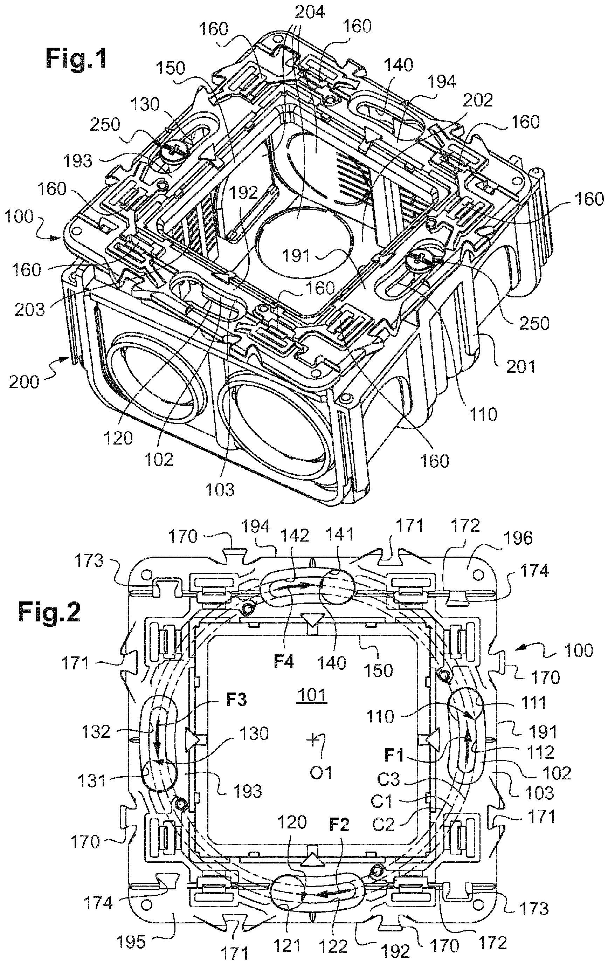

Sur la figure 1, on a représenté un support d'appareillage 100, fixé sur une boîte 200 à rapporter sur une paroi murale.

Dans la description, les termes « avant » et « arrière » seront alors utilisés par rapport à la direction du regard de l'installateur vers la paroi sur laquelle est rapportée la boîte. Ainsi, l'avant d'un élément désignera le côté de cet élément qui est tourné vers l'extérieur de la paroi (côté installateur) et l'arrière désignera le côté opposé.

Ici, la boîte 200 est du type à sceller dans une paroi maçonnée. En variante, cette boîte pourrait être du genre à accrocher dans une cloison creuse ou à fixer en saillie d'une paroi.

Comme le montre la figure 1, cette boîte 200 comporte une paroi latérale 201 qui est fermée à l'arrière par une paroi de fond 202 et qui porte intérieurement deux puits de vissage 203 dans chacun desquels est vissée une vis de fixation 250.

Ici, cette boîte électrique présente une forme parallélépipédique, mais elle pourrait présenter une forme différente, notamment cylindrique.

Elle présente dans sa paroi latérale 201 et dans sa paroi de fond 202 des ouvertures 204 de passage de gaine de cheminement (dans lesquelles peuvent être insérés des fils électriques, des fibres optiques, ...), qui sont initialement obturées par des opercules défonçables.

Cette boîte 200 est prévue pour être scellée dans une paroi murale, de telle manière que son ouverture avant affleure la face avant de la paroi murale et que les axes des deux vis de fixation 250 se retrouvent dans un même plan horizontal.

En pratique, on constate généralement un léger décalage vertical entre les axes de ces deux vis de fixation 250, du fait d'un décalage angulaire de la boîte 200 par rapport à la paroi murale.

Comme le montre la figure 2, le support d'appareillage 100 présente quant à lui une forme de cadre plat et carré, avec quatre branches 191, 192, 193, 194. Ce cadre est défini entre un bord périphérique extérieur et un bord périphérique intérieur qui délimite une ouverture d'accueil 101 d'un ou plusieurs mécanisme(s) d'appareillage non représenté(s) (par exemple un mécanisme d'interrupteur, de prise de courant, de prise de téléphone, un double mécanisme de va-et-vient, ...).

L'ouverture d'accueil 101 délimitée par le support d'appareillage 100 peut accueillir un grand socle de mécanisme d'appareillage ou deux petits socles de mécanismes d'appareillage.

Comme le montre plus particulièrement la figure 1, le support d'appareillage 100 comprend une armature 102 plate en matière métallique, surmoulée d'une peau 103 en matière synthétique isolante.

La peau 103 en matière synthétique isolante recouvre la majeure partie des faces avant et arrière de l'armature 102 plate métallique. Elle recouvre également la tranche de cette armature 102.

L'armature 102 en matière métallique confère une grande rigidité au support d'appareillage 100 et la peau 103 en matière isolante confère à l'utilisateur un sentiment de sécurité électrique en formant une isolation électrique.

La matière isolante constituant la peau 103 est une matière plastique telle qu'un polyamide 6.6. Elle est surmoulée sur l'armature 102.

En variante, le support pourrait être réalisé entièrement en matière plastique (typiquement en ABS) ou en matière métallique (typiquement en acier). Il pourrait ainsi notamment être moulé d'une seule pièce en matière plastique.

Comme le montre la figure 2, chacune des quatre branches 191, 192, 193, 194 du support d'appareillage 100 présente en son centre un orifice 110, 120, 130, 140 en forme de trou de serrure, c'est-à-dire présentant une majeure partie allongée 112, 122, 132, 142 et une extrémité circulaire 111, 121, 131, 141.

Les quatre orifices 110, 120, 130, 140 sont répartis sur un même cercle moyen C1 centré par rapport au cadre. Chaque orifice 110, 120, 130, 140 est ici courbé autour du centre O1 de ce cercle moyen C1.

Plus précisément ici, la partie allongée 112, 122, 132, 142 de chaque orifice 110, 120, 130, 140 est délimitée entre deux bords latéraux chacun circonscrit à un cercle C2, C3 centré autour du centre O1.

Chaque orifice 110, 120, 130, 140 permet le passage du corps fileté de l'une des vis de fixation 250.

Ainsi est-il possible de rapporter le support d'appareillage 100 sur la boîte électrique 200 en enfilant les têtes des deux vis de fixation 250 au travers des extrémités circulaires 111, 121, 131, 141 de deux des orifices 110, 120, 130, 140 du support.

En faisant pivoter le support d'appareillage 100 autour de son centre O1, il est ensuite possible de faire coulisser les parties allongées 112, 122, 132, 142 de ces deux orifices 110, 120, 130, 140 le long des corps filetés des deux vis de fixation 250.

Puis, en vissant les deux vis de fixation 250 dans leurs puits de vissage, les têtes de ces vis peuvent venir s'appuyer sur les bords des parties allongées 112, 122, 132, 142 de ces deux orifices 110, 120, 130, 140, ce qui permet de bloquer fixement le support d'appareillage 100 par rapport à la boîte électrique 200.

On remarque sur la figure 1 que la peau 103 forme autour de chaque orifice 110, 120, 130, 140 une surépaisseur et, qu'à cet endroit, l'armature 102 en matière métallique est apparente. C'est donc contre l'armature 102 métallique du support que s'appuient les têtes des vis de fixation 250.

Selon une caractéristique particulièrement avantageuse de l'invention, les orifices 110, 120, 130, 140 sont situés de telle manière que les extrémités circulaires 111, 141 de deux premiers orifices 110, 140 voisins sont tournées l'une vers l'autre et que les extrémités circulaires 121, 131 des deux autres orifices 120, 130 voisins sont tournées l'une vers l'autre.

Ainsi, si on considère que chaque orifice 110, 120, 130, 140 est orienté autour du centre O1 selon un sens (depuis son extrémité circulaire vers sa partie allongée), les orifices situés dans deux branches opposées du support sont orientés selon un même sens (par exemple dans le sens horaire), tandis que les deux autres orifices sont orientés dans le sens opposé (dans le sens trigonométrique). Cette orientation est illustrée sur la figure 2 par les flèches F1, F2, F3, F4.

Ces flèches illustrent donc le sens dans lequel il convient de faire pivoter le support d'appareillage 100 par rapport à la boîte 200, après avoir engagé ses orifices sur les deux vis de fixation 250.

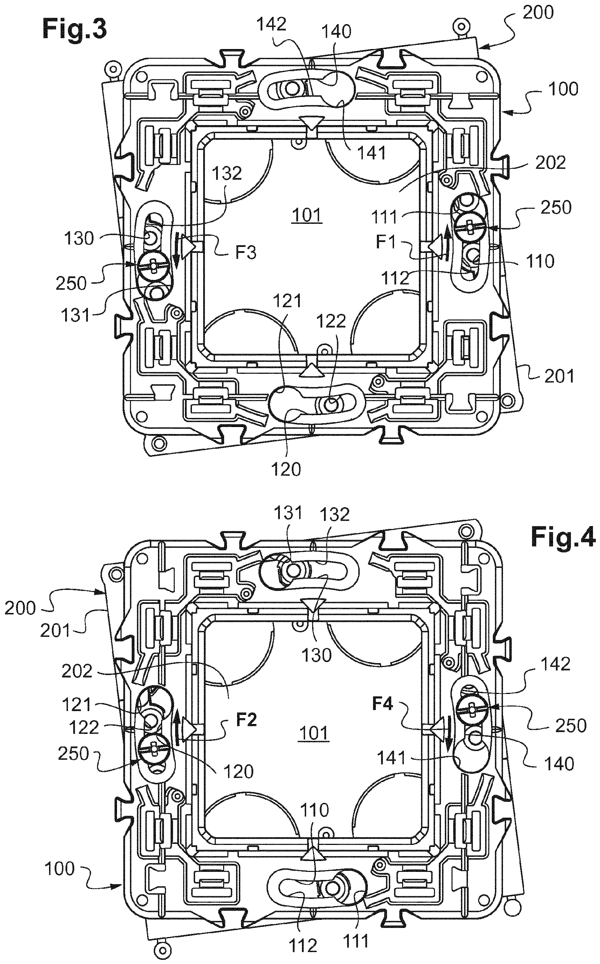

On constate donc que ce sens n'est pas le même selon que c'est l'une des paires d'orifices 110, 130 opposés du support 100 qui a été engagée sur les vis de fixation 250 (figure 3) ou que c'est l'autre des paires d'orifices 120, 140 opposés du support 100 qui a été engagée sur les vis de fixation 250 (figure 4).

Ainsi, comme le montre bien la figure 3, lorsque la boîte 200 n'est pas placée exactement comme souhaité et qu'il est nécessaire d'incliner le support d'appareillage 100 par rapport à la boîte 200 pour le placer à l'horizontal (c'est-à-dire de telle sorte que deux de ses branches s'étendent horizontalement), on peut profiter d'un débattement de quelques degrés offert par la forme allongée et courbée des orifices.

Ce débattement est restreint dans un sens lorsque, comme le montre la figure 3, les têtes des vis de fixation 250 arrivent à hauteur des extrémités circulaires 111, 131 des orifices 110, 130.

Dans ce cas, comme le montre la figure 4, il est préférable de retirer le support d'appareillage 100 en sortant ses orifices 110, 130 hors des vis de fixation 250, de faire pivoter le support d'un quart de tour, puis d'engager ses autres orifices 120, 140 sur les vis de fixation 250.

Comme le montre la figure 1, pour le montage du ou des socles de mécanisme d'appareillage dans le support d'appareillage 100, l'ouverture d'accueil 101 du support est bordée sur ses quatre côtés de moyens d'assujettissement 150. Ces moyens d'assujettissement se présentent ici sous la forme d'une nervure d'accrochage 150 formant un bord tombant à partir de la face avant du support d'appareillage 100.

Sur cette nervure d'accrochage 150 sont destinées à s'accrocher des dents d'encliquetage portées par les socles des mécanismes d'appareillage. L'utilisation de tels moyens d'encliquetage permet de changer l'orientation du mécanisme d'appareillage par rapport au support d'appareillage 100, en le décliquetant du support, en le faisant pivoter d'un quart de tour, et en le réencliquetant sur le support.

Ainsi, à titre d'exemple, on peut envisager le cas d'un mécanisme d'interrupteur dont le socle est encliqueté dans le support d'appareillage 100 et dont la touche avant est montée basculante sur le socle. Alors, si l'installateur fait pivoter le support d'appareillage 100 d'un quart de tour par rapport à la boîte 200 pour les raisons évoquées ci-dessus, il pourra ensuite faire basculer d'un quart de tour le socle du mécanisme d'interrupteur par rapport au support d'appareillage 100, de manière que la touche avant du mécanisme bascule de manière conventionnelle, de haut en bas (et non de gauche à droite).

Par ailleurs, comme le montre la figure 1, il est prévu dans chacune des quatre branches 191, 192, 193, 194 du support d'appareillage 100, de part et d'autre de chaque orifice 110, 120, 130, 140, des moyens d'assujettissement 160 d'une plaque d'habillage (non représentée). Il s'agit ici plus précisément de fentes 160 dans lesquelles peuvent s'accrocher des pattes prévues à l'arrière de la plaque d'habillage.

Comme le montre plus particulièrement la figure 2, le support d'appareillage 100 comporte, sur chacun des quatre côtés de son bord périphérique extérieur, des moyens d'assemblage 170, 171 à un autre support du même type.

Les moyens d'assemblage prévus sur chaque côté comprennent, en saillie de celui-ci, un élément mâle 170 (ici un ergot), et, en creux, un élément femelle 171 (ici une encoche) de contour complémentaire, situé à distance de l'élément mâle, en correspondance avec celui-ci.

Ces moyens d'assemblage permettent alors d'associer le support d'appareillage 100 à un ou plusieurs autres supports du même type, horizontalement ou verticalement, de façon à former une rangée verticale ou horizontale ou même un carré de supports.

L'association de supports est alors ici réalisée avec un entraxe de 71 millimètres, c'est-à-dire de telle sorte que l'écartement entre les centres O1 des supports soit de l'ordre de 71 millimètres.

Le support d'appareillage 100 comporte, sur deux branches 192, 194 parallèles opposées, deux portions détachables 195, 196 qui s'étendent chacune sur toute la longueur de la branche concernée du support 100.

Chaque portion détachable 195, 196 est reliée d'un seul tenant à la branche concernée du support 100 par une ligne de cassure 172 de moindre résistance.

En outre, chaque branche 192, 194 concernée comporte, d'une part, en saillie de ladite ligne de cassure 172, un ergot 173 que ladite portion détachable 195, 196 contourne par une encoche, et, d'autre part, à distance de cet ergot 173 et en correspondance avec celui-ci, une encoche 174 de contour complémentaire.

Ainsi, s'il le souhaite, l'installateur peut casser une des lignes de cassure 172 pour détacher une portion détachable 195, 196 afin de dégager l'ergot 173 et l'encoche 174 correspondante et d'associer ce support d'appareillage 100 à un autre support du même type dont la portion détachable a également été détachée par cassure de la ligne de cassure correspondante.

De cette manière, l'utilisateur peut associer deux supports avec un entraxe de 57 millimètres.

Le support d'appareillage 100 pourra par exemple être utilisé de la manière suivante.

On considérera ici le cas où il est livré avec un mécanisme d'appareillage dont le socle est encliqueté dans son ouverture d'accueil 101. Cet ensemble, appelé « appareillage électrique », est alors destiné à être fixé dans une paroi murale.

Pour cela, une cavité est pratiquée par un installateur dans la paroi murale, puis la boîte 200 est scellée dans cette cavité.

Une gaine de cheminement de câbles est au préalable tirée depuis l'intérieur de cette paroi murale jusqu'à l'intérieur de la boîte 200, au travers de l'une des ouvertures 204 prévue dans la boîte 200.

Les fils électriques courant dans cette gaine sont ensuite connectés au mécanisme d'appareillage.

Les vis de fixation 250 vissées dans les puits de vissage 203 de la boîte 200 sont ensuite partiellement dévissées, de telle manière que le support d'appareillage puisse être engagé sur ces vis via deux de ses orifices 110, 120, 130, 140.

Si l'installateur constate, comme le montre la figure 3, que lorsqu'il est à l'horizontal, le support d'appareillage 100 est en limite de rattrapage angulaire (c'est-à-dire que les têtes des vis de fixation 250 se rapprochent trop des extrémités circulaires 111, 131 des orifices 110, 130 dans lesquels elles sont engagées), il retire le support des vis, l'incline d'un quart de tour, puis le réengage sur les vis, via ses deux autres orifices 120, 140 (voir figure 4). Une fois le support d'appareillage à l'horizontal, l'installeur revisse les vis de fixation 250 de manière qu'elles bloquent le support d'appareillage 100.

L'installateur peut alors, s'il le souhaite, décliqueter le mécanisme d'appareillage pour l'orienter comme il le souhaite, puis le ré-encliqueter sur le support d'appareillage 100.

Enfin, l'installateur rapporte la plaque d'habillage sur le support d'appareillage au moyen des fentes 160 prévues à cet effet.

La présente invention n'est nullement limitée au mode de réalisation décrit et représenté.

Le support d'appareillage pourrait notamment présenter une forme différente, par exemple une forme quasi-circulaire, avec quatre quadrants dans chacun desquels serait prévu un orifice en forme de trou de serrure.

## Revendications

1. Support d'appareillage (100) en forme de cadre qui délimite une ouverture d'accueil (101) d'un mécanisme d'appareillage et qui comporte quatre orifices (110, 120, 130, 140) en formes de trous de serrure répartis sur un même cercle moyen (C1) centré par rapport au cadre, chaque orifice (110, 120, 130, 140) présentant une extrémité circulaire (111, 121, 131, 141) permettant le passage d'une tête de vis et une partie allongée (112, 122, 132, 142) qui est courbée autour du centre (O1) dudit cercle moyen (C1)et qui présente, à l'opposé de l'extrémité circulaire (111, 121, 131, 141), un fond sur le bord duquel peut s'appuyer ladite tête de vis,
**caractérisé en ce que** les orifices (110, 120, 130, 140) sont situés de telle manière que les extrémités circulaires (111, 141) de deux premiers orifices (110, 140) voisins sont tournées l'une vers l'autre et que les extrémités circulaires (121, 131) des deux autres orifices (120, 130) voisins sont tournées l'une vers l'autre.

2. Support d'appareillage (100) selon la revendication précédente, dans lequel la partie allongée (112, 122, 132, 142) de chaque orifice (110, 120, 130, 140) est délimitée entre deux bords latéraux chacun circonscrit à un cercle (C2, C3) centré autour du centre (O1) dudit cercle moyen (C1).

3. Support d'appareillage (100) selon l'une des revendications 1 et 2, comportant une armature (102) plate en matière métallique surmoulée d'une peau (103) en matière synthétique isolante.

4. Support d'appareillage (100) selon l'une des revendications 1 et 2, réalisé d'une seule pièce en matière plastique.

5. Support d'appareillage (100) selon l'une des revendications précédentes, comportant des moyens d'assujettissement (150) d'un mécanisme d'appareillage.

6. Support d'appareillage (100) selon l'une des revendications précédentes, comportant des moyens d'assujettissement (160) d'une plaque d'habillage.

7. Support d'appareillage (100) selon l'une des revendications précédentes, comportant quatre branches (191, 192, 193, 194), dont deux branches sécables (192, 194) opposées présentant chacune une portion détachable (195, 196) qui s'étend sur toute la longueur de la branche concernée et qui est reliée d'un seul tenant au reste de la branche concernée par une ligne de cassure de moindre résistance.

8. Support d'appareillage (100) selon l'une des revendications précédentes, comportant sur chacun des côtés de son bord périphérique extérieur des moyens d'assemblage (170, 171) à un autre support du même type.

9. Support d'appareillage (100) selon les deux revendications précédentes, dans lequel chaque branche sécable (192, 194) comporte sur sa ligne de cassure des moyens d'assemblage (173, 174) à un autre support du même type.

10. Appareillage électrique comportant un support d'appareillage (100) conforme à l'une des revendications précédentes, et un mécanisme d'appareillage fixé dans l'ouverture d'accueil (101) dudit support d'appareillage (100).

11. Appareillage électrique selon la revendication précédente, dans lequel le mécanisme d'appareillage comporte des moyens d'encliquetage démontables, accrochés au bord de l'ouverture d'accueil (101) dudit support d'appareillage (100).

## Patentansprüche

1. Gerätehalterung (100) in Form eines Rahmens, der eine Aufnahmeöffnung (101) für einen Gerätemechanismus begrenzt und der vier Löcher (110, 120, 130, 140) mit der Form von Schlüssellöchern aufweist, die über einen in Bezug auf den Rahmen zentrierten gleichen mittleren Kreis (C1) verteilt sind, wobei jedes Loch (110, 120, 130, 140) ein kreisförmiges Ende (111, 121, 131, 141), das das Hindurchführen eines Schraubenkopfes ermöglicht, und einen länglichen Teil (112, 122, 132, 142), der um den Mittelpunkt (O1) des mittleren Kreises (C1) gebogen ist und der an dem dem kreisförmigen Ende (111, 121, 131, 141) entgegengesetzten Ende einen Boden aufweist, an dessen Rand sich der Schraubenkopf abstützen kann, aufweist,
**dadurch gekennzeichnet, daß** die Löcher (10, 120, 130, 140) so angeordnet sind, daß die kreisförmigen Enden (111, 141) von zwei benachbarten Löchern (110, 140) aufeinander zu gerichtet sind und daß die kreisförmigen Enden (121, 131) von zwei anderen benachbarten Löchern (120, 130) aufeinander zu gerichtet sind.

2. Gerätehalterung (100) gemäß dem vorangehenden Anspruch, bei dem der längliche Teil (112, 122, 132, 142) jedes Lochs (110, 120, 130, 140) zwischen zwei seitlichen Rändern begrenzt ist, von denen jeder einen um den Mittelpunkt (O1) des mittleren Kreises (C1) zentrierten Kreis (C2, C3) umschreibt.

3. Gerätehalterung (100) gemäß einem der Ansprüche 1 und 2, der eine flache Armierung (102) aus einem metallenen Material aufweist, auf das eine Haut (103) aus isolierendem Kunststoff aufgeformt ist.

4. Gerätehalterung (100) gemäß einem der Ansprüche 1 und 2, die in einstückig aus Kunststoff hergestellt ist.

5. Gerätehalterung (100) gemäß einem der vorangehenden Ansprüche, die Befestigungsmittel (150) für einen Gerätemechanismus aufweist.

6. Gerätehalterung (100) gemäß einem der vorangehenden Ansprüche, die Befestigungsmittel (160) für eine Verkleidungskappe aufweist.

7. Gerätehalterung (100) gemäß einem der vorangehenden Ansprüche, die vier Abschnitte (191, 192, 193, 194) aufweist, von denen zwei gegenüberliegende abtrennbare Abschnitte (192, 194) einen abtrennbaren Teil (195, 196) aufweisen, der sich über die gesamte Länge des betreffenden Abschnitts erstreckt und der in einem Stück mit dem Rest des betreffenden Abschnitts über eine Sollbruchlinie verbunden ist.

8. Gerätehalterung (100) gemäß einem der vorangehenden Ansprüche, die auf jeder der Seiten des äußeren umlaufenden Rands Mittel (170, 171) zum Zusammenbauen mit einer anderen Halterung des gleichen Typs aufweist.

9. Gerätehalterung (100) gemäß den beiden vorangehenden Ansprüchen, bei der jeder abtrennbare Abschnitt (192, 194) auf seiner Bruchlinie Mittel (173, 174) zum Zusammenbauen mit einer anderen Halterung des gleichen Typs aufweist.

10. Elektrisches Gerät, das eine Gerätehalterung (100) gemäß einem der vorangehenden Ansprüche und einen in der Aufnahmeöffnung (101) der Gerätehalterung (100) befestigten Gerätemechanismus aufweist.

11. Elektrisches Gerät gemäß dem vorangehenden Anspruch, bei dem der Gerätemechanismus abnehmbare Einschnappmittel aufweist, die am Rand der Aufnahmeöffnung (101) der Gerätehalterung (100) eingehakt sind.

## Claims

1. An accessory support (100) in the shape of a frame that defines a reception opening (101) for receiving an accessory mechanism, and that includes four orifices (110, 120, 130, 140) in the shape of key holes that are distributed on a common mean circle (C1) that is centered relative to the frame, each orifice (110, 120, 130, 140) presenting a circular end (111, 121, 131, 141) and an elongate portion (112, 122, 132, 142) that is curved around the center (O1) of said mean circle (C1), said circular end (111, 121, 131, 141) being designed to enable the passage of a screw head and said elongate portion (112, 122, 132, 142) having an extremity that is situated at the opposite of said circular end (111, 121, 131, 141) and that is able to support the screw head;
the accessory support being **characterized in that** the orifices (110, 120, 130, 140) are situated so that the circular ends (111, 141) of two first adjacent orifices (110, 140) face towards each other, and so that the circular ends (121, 131) of the two other adjacent orifices (120, 130) face towards each other.

2. An accessory support (100) according to the preceding claim, wherein the elongate portion (112, 122, 132, 142) of each orifice (110, 120, 130, 140) is defined between two side edges, each circumscribed by a circle (C2, C3) that is centered on the center (O1) of said mean circle (C1) .

3. An accessory support (100) according to claim 1 or claim 2, comprising flat reinforcement (102) made out of metal, embedded in a skin (103) made out of synthetic insulating material.

4. An accessory support (100) according to claim 1 or claim 2, made as a single piece out of plastics material.

5. An accessory support (100) according to any preceding claim, including securing means (150) for securing an accessory mechanism.

6. An accessory support (100) according to any preceding claim, including securing means (160) for securing a cover plate.

7. An accessory support (100) according to any preceding claim, comprising four branches (191, 192, 193, 194), two opposite of which are breakable branches (192, 194), each of these breakable branches (192, 194) presents a detachable portion (195, 196) that extends over the entire length of the branch under consideration and is integrally connected to the remainder of the branch under consideration via a breakable line of weakness.

8. An accessory support (100) according to any preceding claim including, on each of the sides of its outer peripheral edge, assembly means (170, 171) for assembling to another support of the same type.

9. An accessory support (100) according to the two preceding claims, wherein, on its line of weakness, each breakable branch (192, 194) includes assembly means (173, 174) for assembling to another support of the same type.

10. An electrical accessory comprising an accessory support (100) in accordance with any preceding claim, and an accessory mechanism that is fastened in the reception opening (101) of said accessory support (100).

11. An electrical accessory according to the preceding claim, wherein the accessory mechanism includes releasable snap-fastener means attached to the edge of the reception opening (101) of said accessory support (100) .
